Europäisches Patentamt

European Patent Office

Office européen des brevets

(19)

(11) **EP 0 522 191 B1**

(12) **EUROPÄISCHE PATENTSCHRIFT**

(45) Veröffentlichungstag und Bekanntmachung des Hinweises auf die Patenterteilung:
   **26.06.1996   Patentblatt 1996/26**

(51) Int Cl.[6]: **G01R 33/24**, G01R 33/38

(21) Anmeldenummer: **91111546.7**

(22) Anmeldetag: **11.07.1991**

(54) **Verfahren und Vorrichtung zum Kompensieren von Feldstörungen in Magnetfeldern**

Method and apparatus for compensating field disturbances in magnetic fields

Procédé et dispositif pour la compensation de perturbations de champs dans des champs magnétiques

(84) Benannte Vertragsstaaten:
   **CH DE FR GB LI**

(43) Veröffentlichungstag der Anmeldung:
   **13.01.1993   Patentblatt 1993/02**

(73) Patentinhaber: **SPECTROSPIN AG**
   **CH-8117 Fällanden (CH)**

(72) Erfinder:
   • **Schett, Oskar**
   **CH - 8610 Uster (CH)**
   • **Schwilch, Arthur**
   **CH - 8603 Schwerzenbach (CH)**

(74) Vertreter: **KOHLER SCHMID + PARTNER**
   **Patentanwälte**
   **Ruppmannstrasse 27**
   **70565 Stuttgart (DE)**

(56) Entgegenhaltungen:
   **CH-A- 466 611        GB-A- 2 019 006**

   • **JOURNAL OF PHYSICS E. SCIENTIFIC INSTRUMENTS. Bd. 2, Nr. 10, 1. Oktober 1969, ISHING, BRISTOL GB Seiten 846 - 850; M. BIRKLE U.A.: 'MODULATION EFFECTS AND THEIR APPLICATION IN HIGH RESOLUTION NUCLEAR RESONANCE SPECTROMETERS'**
   • **REVIEW OF SCIENTIFIC INSTRUMENTS. Bd. 46, Nr. 5, 1. Mai 1975, NEW YORK US Seiten 617 - 619; B.W. BANGERTER: 'FIELD/FREQUENCY LOCK MONITOR FOR SIGNAL AVERAGING WITH HIGH RESOLUTION NMR SPECTROMETERS'**
   • **JOURNAL OF PHYSICS E. SCIENTIFIC INSTRUMENTS. Bd. 9, Nr. 4, 1. April 1976, ISHING, BRISTOL GB Seiten 283 - 286; J.K. HULBERT: 'A FIELD TRACKING DIGITAL NMR MAGNETOMETER FOR IN SITU USE WITH SUPERCONDUCTING SOLENOIDS'**

**Beschreibung**

Die Erfindung betrifft ein Verfahren zum Kompensieren von zeitvarianten Feldstörungen in Magnetfeldern von Elektromagneten mit hoher Feldhomogenität, insbesondere in Probenräumen von supraleitenden Elektromagneten für Messungen magnetischer Resonanz, bei welchem Verfahren das Dispersionssignal $u_x$ des magnetischen Kernresonanzsignals einer Vergleichssubstanz aufgenommen wird und zur Kompensation durch Erzeugen eines von dem Dispersionssignal abhängigen Stroms in einer Feldkorrekturspule des Elektromagneten herangezogen wird.

Ein solches Verfahren und die entsprechende Vorrichtung ist aus CH-A-466 611 bekannt.

Bei der bekannten NMR-Feldstabilisierung wird das Dispersionssignal $u_x$ des magnetischen Kernresonanzsignals verwendet. Das Dispersionssignal gibt bei einer Abweichung des magnetischen Kernresonanzsignals von der Soll-Frequenz durch sein Vorzeichen unmittelbar an, in welche Richtung die Kompensation zu erfolgen hat. Das Absorptionssignal $u_y$ wird für die NMR-Feldstabilisation, den sogenannten NMR-Lock, nicht verwendet, sondern nur für die Anzeige des eingerasteten Regelzustandes für die Homogenisierung des Magnetfelds durch sogenanntes "Shimmen". Das Absorptionssignal ist bekanntlich gegenüber dem Dispersionssignal um 90° in der Phase verschoben.

Man ist bestrebt, die NMR-Feldstabilisierung möglichst genau vorzunehmen, um das Magnetfeld so genau wie möglich konstant zu halten. Dabei sollen sowohl kleine Störamplituden, die zu einer kleinen Frequenzänderung der Vergleichssubstanz führen, als auch relativ große externe magnetische Störamplituden kompensiert werden können. Die Erfindung schafft eine neuartige Möglichkeit für die NMR-Feldstabilisierung.

Gemäß der Erfindung ist vorgesehen, daß zusätzlich das Absorptionssignal $u_y$ der Vergleichssubstanz aufgenommen wird, und daß die Kompensation in Abhängigkeit von den Größen $u_x/u_y$ oder $(1/u_y)(du_x/dt)$ oder einer gewichteten Kombination derselben vorgenommen wird. Der Vorteil liegt dabei darin, daß die genannten Größen weitgehend unabhängig von zahlreichen Einflußgrößen sind, wie unten ausgeführt wird, so daß eine genaue Feldkompensation erleichtert ist. Dies wird dadurch möglich, daß erfindungsgemäß das Dispersionssignal mit dem Absorptionssignal der Vergleichssubstanz kombiniert wird.

Die erwähnte geeignet zu wählende Gewichtung kann dazu führen, daß im Einzelfall ausschließlich eine einzige der genannten Größen für die Kompensation verwendet wird.

Bei einer Ausführungsform der Erfindung ist vorgesehen, daß die Kompensation in Abhängigkeit von der Größe $1/T_2 \cdot u_x/u_y$ vorgenommen wird, wobei $T_2$ die Spin-Spin-Relaxationszeit der Vergleichssubstanz ist. Ein Vorteil liegt hierbei darin, daß diese Größe bei kleinen Störfrequenzen und bei bekanntem $T_2$ die Störamplitude (entsprechend einer durch die Störung bedingten Abweichung der Frequenz des magnetischen Kernresonanzsignals der Vergleichssubstanz) unmittelbar ermittelt werden kann, siehe Formel 1.38. Diese Größe eignet sich vor allem zur Regelung von Feldstörungen im normalen Betriebszustand bei kleinen Störamplituden, weil diese Größe verhältnismäßig wenig Rauschanteile enthält und daher eine genaue Feinregelung erlaubt. Zum zusätzlichen Unterdrücken von etwa vorhandenen Rauschkomponenten kann es zweckmäßig sein, die praktisch konstant bleibende Größe $u_y$ durch einen Tiefpaß zu filtern.

Bei einer Ausführungsform der Erfindung ist vorgesehen, daß die Kompensation in Abhängigkeit von der Größe $1/T_2 \cdot u_x/u_y + +1/u_y \cdot du_x/dt$ vorgenommen wird. Der Vorteil besteht darin, daß diese Gleichung exakt gilt und an keine Bedingungen gebunden ist. Diese Größe erlaubt eine Grobregelung bei großen Störamplituden mit guten Dynamikeigenschaften. Für eine Feinregelung sollte diese Größe nicht unbedingt verwendet werden, weil diese Größe mit Rauschanteilen behaftet ist, die allerdings bei einer Grobregelung weniger ins Gewicht fallen. Bei dieser Grobregelung ist dagegen von besonderem Vorteil, daß die großen Störamplituden berechnet und sofort kompensiert werden können. Die Verwendung dieser Größe zur Kompensation verbessert den Halte- und Fangbereich der Regelung und vermeidet dadurch in vielen Fällen, daß der Fangbereich der Regelung verlassen wird. Bei einer Ausführungsform der Erfindung werden die genannten Größen und vorzugsweise auch die aus diesen abgeleiteten Regelsignale durch digitale Berechnung ermittelt. Ein Vorteil besteht darin, daß dann durch einfache Programmänderung Anpassungen vorgenommen werden können. Es wird jedoch ausdrücklich darauf hingewiesen, daß die Regelung erfindungsgemäß auch unter Verwendung von herkömmlichen elektronischen Schaltungen vorgenommen werden kann.

Eine erfindungsgemäße Vorrichtung zur Durchführung des erfindungsgemäßen Verfahrens weist einen phasenempfindlichen Gleichrichter zum Gewinnen des Dispersionssignals $u_x$, wie er an sich aus CH-A-466 611 bekannt ist, einen phasenempfindlichen Gleichrichter zum Gewinnen des Absorptionssignals $u_y$ eines magnetischen Kernresonanzsignals und eine Vorrichtung zum Erzeugen einer von $u_x/u_y$, $(1/u_y)(du_x/dt)$ oder einer Kombination davon abhängigen Größe auf, wobei diese Größe der Vorrichtung zur Kompensation zugeführt wird. Diese Vorrichtung und ihre Ausführungsformen weisen die oben abgehandelten Vorteile auf.

Bei einer Ausführungsform der Erfindung ist vorgesehen, daß mindestens einem Meßumformer ein Regler nachgeschaltet ist, an dessen Ausgang das entsprechend den Regeleigenschaften modifizierte Eingangssignal des betreffenden Reglers erscheint. Dadurch kann das von einem Meßumformer gelieferte Signal modifiziert werden.

Bei einer Ausführungsform der Erfindung ist vorgesehen, daß sie eine Schaltvorrichtung zum Auswählen der einen Größe oder der anderen Größe oder einer Kombination der Größen aufweist; hierdurch kann das gewünschte Signal ausgewählt werden.

Bei einer Ausführungsform der Erfindung ist vorgesehen, daß sie eine Steuervorrichtung aufweist, die in Abhängigkeit von dem Dispersionssignals $u_x$ und dem Absorptionssignals $u_y$ die Regler und/oder die Schaltvorrichtung steuert; hierdurch kann in einfacher Weise unter Berücksichtigung des Dispersionssignals und des Absorptionssignals das Ausgangssignal des einen oder anderen Meßumformers beeinflußt und/oder eine Kombination der beiden Ausgangssignale zur Kompensation der Feldänderung verwendet werden.

Bei einer Ausführungsform der Erfindung ist ein Digitalrechner vorgesehen, der die genannten Größen ermittelt. Bei einer Ausführungsform der Erfindung ist ein außerhalb des Elektromagneten angeordneter Feldsensor vorgesehen, um schnelle Feldschwankungen von externen Störquellen zu kompensieren.

Weitere Merkmale und Vorteile ergeben sich aus der Beschreibung eines Ausführungsbeispiels der Erfindung anhand der Zeichnung, die erfindungswesentliche Einzelheiten zeigt, und aus den Ansprüchen.

Es zeigen:

Fig. 1    Das Gesamtschema einer Stabilisierungsvorrichtung,
Fig. 2    ein Funktionsschema des Rechners der Fig. 1,
Fig. 3    den Feldvektor $\vec{H}$ im kartesischen Koordinatensystem,
Fig. 4    den Magnetvektor $\vec{M}$ im kartesischen Koordinatensystem,
Fig. 5    die Zeitfunktion einer Schaltfunktion,
Fig. 6    das Frequenzspektrum der gleichen Schaltfunktion wie in Fig. 5,
Fig. 7    Meßgrößen zum Bestimmen von $T_2$.

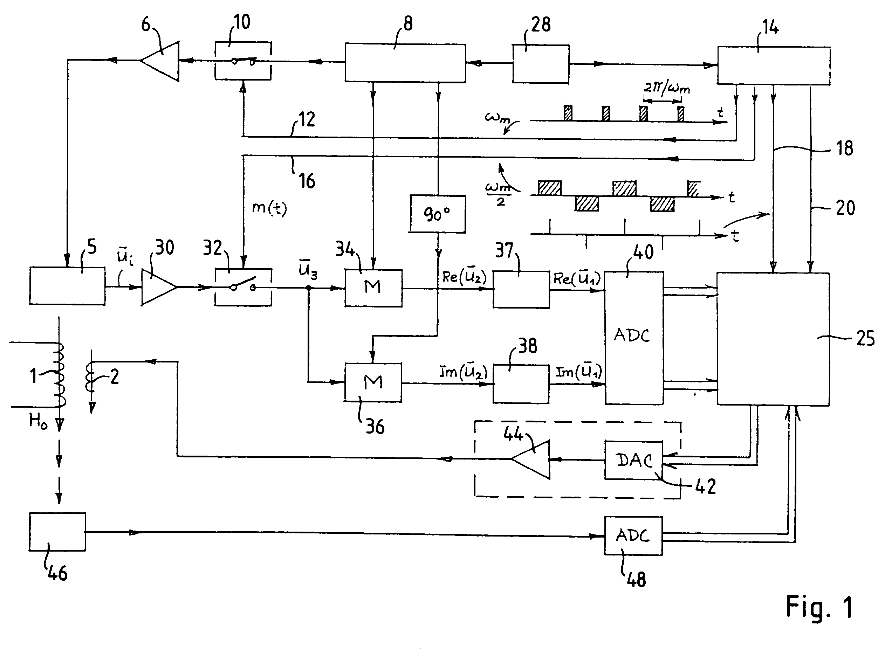

In Fig. 1 sind die zum Verständnis der Erfindung erforderlichen Teile eines NMR-Spektrometers und eine erfindungsgemäße Stabilisierungsvorrichtung dargestellt. Das NMR-Spektrometer weist eine Feldspule 1 auf, bei der es sich um eine supraleitende Spule handeln kann, die zur Erzeugung des Feldes $H_0$ dient, das eine sehr große Feldhomogenität aufweisen soll, vorzugsweise eine Inhomogenität von weniger als $10^{-5}$. Koaxial zur Feldspule 1 (in Fig. 1 der besseren Unterscheidung wegen jedoch im Abstand dargestellt) ist eine nicht supraleitende Feldkorrekturspule 2 vorgesehen, der Ströme zur Kompensation von zeitlichen Änderungen des magnetischen Felds $H_0$ zugeführt werden. Das von der Feldkorrekturspule 2 erzeugte Magnetfeld wird hier mit ΔHreg bezeichnet. Es ist ein Probenkopf 5 vorgesehen, dem, wie üblich, HF-Impulse zur Anregung der kernmagnetischen Resonanz innerhalb einer Probe zugeführt werden und der die Kernspinsignale aufnimmt. Zur Speisung des Probenkopfes 5 dient ein HF-Sender 6, dessen Eingang mit einem HF-Generator 8 verbunden ist, wobei die Erzeugung von HF-Impulsen durch einen zwischen die beiden zuletzt genannten Elemente geschalteten Schalter 10 symbolisiert ist. Der Schalter 10 wird über eine Steuerleitung 12 mit Schaltimpulsen versorgt, die von einem NF-Generator 14 erzeugt werden. Die Schaltimpulse sind im dargestellten Beispiel Rechteckimpulse mit gleicher Polarität und der Folgefrequenz (Kreisfrequenz) $\omega_m$.

Der NF-Generator 14 erzeugt auf einer Steuerleitung 16 ein weiteres Steuersignal aus rechteckförmigen Impulsen mit wechselnder Polarität und der Impulsfolgefrequenz $\omega_m/2$. Ferner liefert der NF-Generator auf einer Steuerleitung 18 ein Referenzsignal ebenfalls mit der Frequenz $\omega_m/2$ und auf einer Taktleitung 20 ein Taktsignal. Die beiden letztgenannten Signale werden einem digital arbeitenden Rechner 25 zugeführt. Der HF-Generator 8 und der NF-Generator 14 werden von einem Basisoszillator 28 gesteuert.

Das Ausgangssignal des Probenkopfes 5, das Kernspinsignal $\bar{U}_i$ wird über einen Verstärker 30 und einen gesteuerten Schalter 32, dessen Steuereingang mit der Steuerleitung 16 verbunden ist, zwei Mischern 34 und 36 zugeführt. Der Schalter 32 bewirkt entsprechend dem ihm zugeführten Steuersignal (Funktion m(t)) eine abwechselnde Umpolung. Die Mischer werden von dem HF-Generator mit der gleichen, jedoch um 90° phasenverschobenen Hochfrequenz versorgt, wobei im Beispiel das Ausgangssignal der beiden Mischer im NF-Bereich liegt. Stattdessen könnte das Umsetzen in den NF-Bereich auch über eine oder mehrere Zwischenfrequenzstufen erfolgen. Die Ausgangssignale der beiden Mischer 34 und 36 sind mit Re ($\bar{U}_2$) bzw. Im ($\bar{U}_2$) bezeichnet, also als Realteil und Imaginärteil von $\bar{U}_2$. Diese Signale werden jeweils über ein NF-Filter 37 bzw. 38 Eingängen eines Analog-Digital-Wandlers 40 zugeführt. Ausgänge dieses Wandlers sind mit Eingängen des Rechners 25 verbunden. Ausgangssignale des Rechners 25 werden einem Digital-Analog-Wandler 42 zugeführt, dessen analoges Ausgangssignal über einen Verstärker 44 zur Feldkorrekturspule 2 geleitet wird. Der Digital-Analog-Wandler 42 und der Verstärker 44 bilden eine steuerbare Stromquelle.

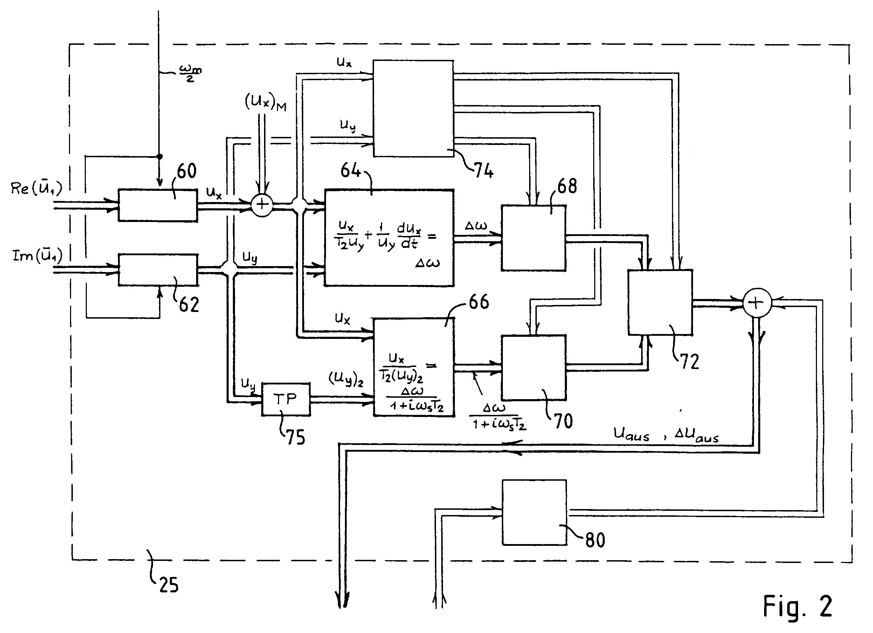

Schnelle durch externe Störungen (z. B. starke Stromschwankungen in dem Fahrdraht einer benachbarten elektrischen Straßenbahn) verursachte Feldänderungen werden von einem Feldsensor 46 erfaßt und über einen Analog-Digital-Wandler 48 dem Rechner 25 zugeführt der entsprechende Korrektursignale erzeugt und dem Digital-Analog-Wandler 42 zuführt. Ein in Fig. 2 eingezeichneter Kompensator 80 bewirkt eine frequenzabhängige Beeinflussung der Kompensation dieser Störungen.

Im Rechner 25 werden die in digitaler Form vorliegenden Ausgangssignale der NF-Filter 37 und 38 unter Verwendung des auf der Signalleitung 18 gelieferten Referenzsignals, dessen Impulsform in Fig. 1 eingezeichnet ist, einer synchronen Gleichrichtung unterzogen, was durch Funktionsblöcke 60 und 62 angedeutet ist. Die gleichgerichteten

Signale $u_x$ bzw. $u_y$ werden jeweils einer ersten Meßumformung 64 und einer zweiten Meßumformung 66, versinnbildlicht durch einen entsprechenden Meßumformer 1 und Meßumformer 2 nach den dort eingetragenen Formeln umgeformt. Das Signal $u_y$ wird dabei der Meßumformung 66 über einen Tiefpaß, dessen Ausgangssignal mit $(u_y)_2$ bezeichnet ist, zugeführt. Die Ausgangssignale der Meßumformer werden über ebenfalls rein rechnerisch verwirklichte Regler 68 und 70 einem gesteuerten Schalter 72 zugeführt, der das Ausgangssignal des Reglers 1, des Reglers 2 oder eine Kombination beider Ausgangssignale auswählt und das ausgewählte Signal dem Digital-Analog-Wandler 42 zuführt.

Die in Fig. 2 aufgezeichneten Funktionsblöcke dienen dem besseren Verständnis der Funktionsweise und sind rein rechnerisch realisiert. Die beiden in Quadratur zueinander stehenden Kernspinsignale $u_x$ und $u_y$ werden in zwei parallel verlaufenden Berechnungsketten bestehend aus Meßumformer und Regler verarbeitet und im Schalter entweder einzeln durchgeschaltet oder mit geeigneten Gewichtungen zuerst addiert und anschließend durchgeschaltet.

Es ist eine Reglersteuerung 74 vorgesehen, die unter Berücksichtigung der Signale $u_x$ und $u_y$ anhand einer gespeicherten Tabelle Regelparameter für die beiden Regler 68 und 70 und Schaltbefehle für den Schalter 72 erzeugt.

Die in Fig. 1 und 2 eingezeichneten Signale und Spannungswerte beziehen sich auf die unten folgenden Bezeichnungen und Berechnungen.

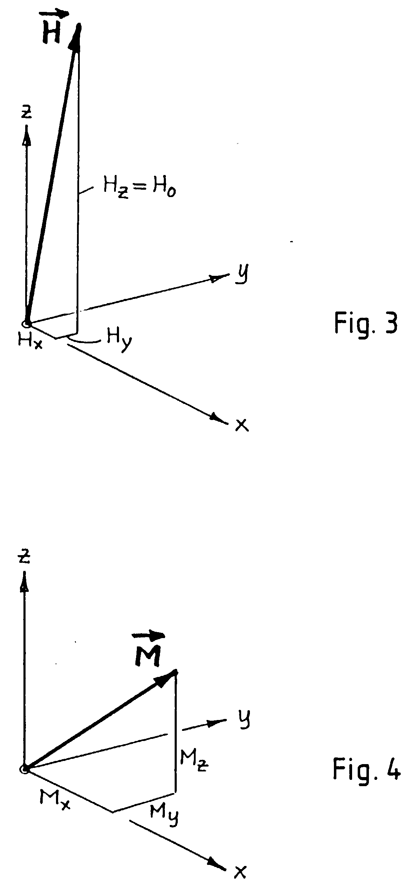

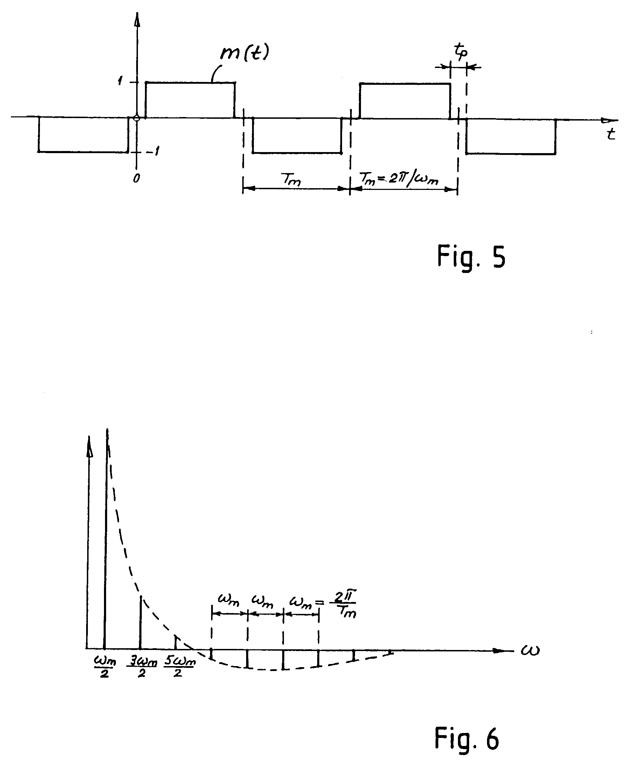

Die in Fig. 3 und 4 gezeigten Vektoren sowie die in Fig. 5 und 6 gezeigte Schaltfunktion m (t) sind bekannt und werden bei der nachfolgenden Besprechung verwendet.

Ein NMR-Feldstabilisator benützt das Kernresonanzsignal, um eine feldproportionale Meßgröße abzuleiten, mit der dann eine Regulierung der $H_0$-Feldstärke auf eine konstante Größe erreicht werden kann.

Unten wird das Kernresonanzsignal mathematisch abgeleitet. Ausgehend von den Bloch'schen Gleichungen, die das Kernspinsystem charakterisieren, wird das in der Empfangsspule induzierte Signal berechnet, die Modulation dieses Signals durch das Ein- und Ausschalten des Empfängers berücksichtigt, eine Quadraturdetektion mit anschließender Synchrongleichrichtung mit einbezogen und schließlich werden die Ausgangssignale $u_x$ und $u_y$ der beiden Quadraturkanäle ermittelt.

Um das vorgeschlagene Verfahren elegant und leicht modifizierbar ausführen zu können, wurde ein großer Teil der Funktionseinheiten rechnerisch realisiert. Damit erreicht man ein Höchstmaß an Flexibilität, indem die maßgebenden Parameter und Operationen softwaremäßig realisiert sind und leicht abgeändert werden können.

Geht man von einer gegebenen Feldstörung $\gamma\Delta H_0 \cos \omega_s t = \Delta\omega \cos \omega_s t$ aus, mit genügend kleiner Störamplitude $\Delta\omega$ (d.h. $(\Delta\omega)^2 T_2^2 \ll 1$) und der Störfrequenz $\omega_s$ und berechnet den Einfluß dieser Störung auf die Kernspinsignale $u_x$ und $u_y$, so führt dies zu den Gleichungen (1.32) und (1.33). Man erkennt daraus, daß diese Feldstörung keinen Einfluß auf $u_y$ hat und nur in $u_x$ zum Vorschein kommt. $u_y$ ist in Gleichungen (1.36) nochmals angeschrieben und zwar als Zeiger in der komplexen Ebene. Der Klammerausdruck stellt exakt die Übertragungsfunktion eines Tiefpasses dar und charakterisiert die Trägheit des Kernspinsystems, das auf sehr schnelle Feldschwankungen kaum reagiert.

Aus (1.36) ist ferner zu erkennen, daß $u_x$ von sehr vielen Parametern wie Empfangsverstärkung $k_{tot}$, Senderamplitude $H_1$, Sättigungsparameter $\gamma^2 H_1^2 T_1 T_2$, usw. abhängt. Dividiert man hingegen $\bar{U}_x$ durch $u_y$, dann fallen alle diese Parameter heraus und es entsteht die überaus einfache Gleichung (1.37).

Dieser Divisionsvorgang kann bereits als ein adaptiver Vorgang betrachtet werden, der verschiedene veränderliche Parametereinflüsse berücksichtigt und in diesem Fall kompensiert.

Eine weitere wichtige Beziehung ist die Gleichung (1.39). Sie liefert direkt den genauen Wert der Störamplitude auch bei großen Werten von $\Delta\omega$. Sie benötigt aber dazu, neben der Größe $u_x/(T_2 u_y)$, die schon aus (1.38) bekannt ist, auch noch den Differentialquotienten $du_x/dt$. Diese Differenzierung bringt jedoch auch einen Nachteil mit sich, indem das Frequenzspektrum des Rauschsignals proportional zur Frequenz angehoben wird und dadurch die Berechnung von $\Delta\omega$ ungenau wird.

Für kleine Störamplituden $\Delta\omega$ darf $u_y$ als konstant angenommen werden und dann stellt die Gleichung (1.39) eine lineare Differentialgleichung dar, welche auch filtertechnisch realisiert werden könnte. Der Amplitudengang dieses Filters würde bis zur Frequenz $\omega = 1/T_2$ flach verlaufen und von dort mit 20db/Dekade ansteigen. Die komplexe Übertragungsfunktion $\bar{E}$ dieses Filters wäre gegeben durch

$$\bar{E} = 1 + i\omega_s T_2$$

und man sieht, daß dieses Filter den Tiefpaß-Charakter von $u_x$ (siehe Gleichung 1.37) genau kompensieren und eine zu $\Delta\omega$ exakt proportionale Größe ergeben würde.

Die Gleichung (1.39) kann jedoch mehr als obiges Filter, indem sie auch unter dem Einfluß großer Störamplituden, wenn $u_y$ nicht mehr als konstant angenommen werden darf, den Wert $\Delta\omega$ richtig bestimmt. Man beachte, daß sobald $u_y$ nicht mehr konstant ist, diese Gleichung eine nichtlineare Differentialgleichung darstellt und damit auch den bekannten nichtlinearen Charakter des Kernspinsystems zum Ausdruck bringt.

Da der 1.Meßumformer 64 eine von der Störfrequenz $\omega_s$ unabhängige Größe $\Delta\omega$ abgibt, d.h. einen flachen Amplitudengang besitzt, genügt es zur Erfüllung des Stabilitätskriteriums in der einfachsten Ausführungsform den 1.Regler 68 als Verstärker mit Tiefpaßcharakter auszuführen. Der 2.Meßumformer 66 liefert bereits ein Signal mit Tiefpaßcharakter, so daß in der einfachsten Ausführungsform der 2.Regler 70 als Verstärker mit flachem Amplitudengang ausgelegt werden kann.

In beiden Fällen erreicht man verbesserte Eigenschaften, wenn in den beiden Reglern zusätzlich noch integrierende oder besser noch doppelt integrierende Glieder eingesetzt werden, die aber aus regelungstechnischen Stabilitätsgründen ihr integrierendes Verhalten nur im unteren Frequenzbereich der Regelbandbreite ausüben dürfen.

Der 1.Kanal mit dem 1.Meßumformer 64 und dem 1.Regler 68 besitzt ausgezeichnete Dynamikeigenschaften und eignet sich vor allem als Grobregelung bei großen störamplituden $\Delta\omega$, weil dann der Nachteil des stärkeren Rauschens in diesem Kanal weniger ins Gewicht fällt, gegenüber dem Vorteil einer exakten Berechnung von $\Delta\omega$. Dieser 1.Kanal verbessert auch den Halte- und Fangbereich der Regelung und vermeidet damit vielfach, daß diese aus dem verriegelten Zustand fällt.

Der 2.Kanal mit dem 2.Meßumformer 66 und dem 2.Regler 70 besitzt eine durch $T_2$ begrenzte Dynamikeigenschaft und eignet sich für den normalen Betriebszustand und bei kleinen Störamplituden, weil er vor allem weniger rauscht und somit eine genauere Feinregelung erlaubt. Da in diesem Fall $u_y$ bei kleinen Störamplituden praktisch konstant bleibt, wird dieses Signal zuerst über einen Tiefpaß 75 geleitet, bevor es dem 2.Meßumformer 66 zur Verfügung gestellt wird. Dadurch werden zusätzlich vorhandene Rauschkomponenten herausgefiltert.

Die Regler-Steuerung 74 berechnet aus den beiden Kernspinsignalen $u_x$ und $u_y$ die optimalen Parameter für die Regler 68 und 70 und mit welcher Gewichtung die beiden Methoden der Meßumformung in den Regelkreis eingebaut werden. Im normalen Betriebszustand und wenn nur kleine Störamplituden vorhanden sind, wird sie den 2.Kanal bevorzugen und den 1.Kanal ausschalten. Sobald große Störungen auftreten, läßt sich dies insbesondere am Signal $u_x$ feststellen und die Regler-Steuerung schaltet den 1.Kanal dazu oder schaltet vollständig auf den 1.Kanal um und zwar solange, bis die Störung wieder verschwunden ist. Anschließend wird wieder auf den 2.Kanal umgeschaltet. Sind andauernd größere Störungen vorhanden, dann werden beide Kanäle aktiviert und die Gewichtungsverteilung zwischen diesen beiden Kanälen so gewählt, daß ein optimaler Kompromiß zwischen Störunterdrückung und Rauschminimierung erreicht wird. Da alle diese Vorgänge rechnerisch erfolgen, ist es sehr einfach, auch andere Gewichtungsmethoden anzuwenden. Insbesondere können durch Veränderung der Regelparameter auch die Frequenzgänge der beiden Regler je nach Größe der Störamplitude verändert und optimiert werden.

Die Relaxationszeit $T_2$, die in den beiden Meßumformern 64 und 66 für die Berechnung benötigt wird, kann in erster Annäherung als geschätzter Wert eingegeben werden. Um die Regelung jedoch besser optimieren zu können, muß $T_2$ genauer bekannt sein. Dies läßt sich durch einen speziellen Meßvorgang erreichen, indem durch Addition eines Signals $(u_x)_M$ an einer geeigneten Stelle des Regelkreises ein vorausbestimmbares Dispersionssignal $u_x$ entsteht. Eine geeignete Stelle für diese Addition ist der Ausgang des synchronen Gleichrichters 60 im x-Kanal (siehe Fig. 2). Der Feldstabilisator reagiert auf diesen Eingriff, indem er über den 2.Regler 70, die Stomquelle 42, 44 und die Feldkorrekturspule 2 eine Feldänderung erzeugt, welche zu einem Dispersionssignal $u_x$ führt, mit dem der Feldstabilisator das eingespeiste Signal $(u_x)_M$ zu kompensieren versucht. Dies wird er umso genauer erreichen, je größer die Verstärkung des 2.Reglers 70 und der Stromquelle ist. Bei genügend großer Verstärkung und nach Erreichung des stationären Zustandes gilt somit

$$u_x = -(u_x)_M$$

Im stationären Zustand gilt zudem $\omega_s = 0$ und $u_y = (u_y)_2$ und Gleichung (1.38) reduziert sich auf

$$\Delta\omega = \frac{1}{T_2}\frac{u_x}{(u_y)_2} = \frac{1}{T_2}\frac{-(u_x)_M}{(u_y)_2}$$

$$T_2 = \frac{-(u_x)_M}{\Delta\omega\,(u_y)_2}$$

Im rechten Teil dieser Gleichung ist alles bekannt bis auf die Frequenzveränderung $\Delta\omega = \gamma\Delta H_0$, welche aber über die in der Feldkorrekturspule 2 erzeugte Feldänderung $\Delta H_0$ ermittelt werden kann. $\Delta H_0$ wird nämlich durch eine Signaländerung $\Delta u_{aus}$ erzeugt, die am Ausgang des Rechners 25 gemessen werden kann (siehe Fig. 2) und da die Beziehung $\Delta H_0/\Delta u_{aus} = g_0$ bekannt ist, erhält man für $\Delta\omega$ :

$$\Delta H_0 = g_0\Delta u_{aus}$$

$$\Delta\omega = \gamma\Delta H_0 = \gamma g_0\Delta u_{aus}$$

Eingesetzt in die Gleichung für $T_2$:

$$T_2 = \frac{-(u_x)_M}{\gamma g_0\Delta u_{aus}\,(u_y)_2}$$

Man beachte, daß bei dieser Messung der Kompensator 80 (siehe Fig. 2), der später noch beschrieben werden soll, ausgeschaltet sein muß. Man beachte ferner, daß die oben beschriebene Messung von $T_2$ im eingeschalteten

Betriebszustand des Feldstabilisators, d.h. bei geschlossenem Regelkreis erfolgt.

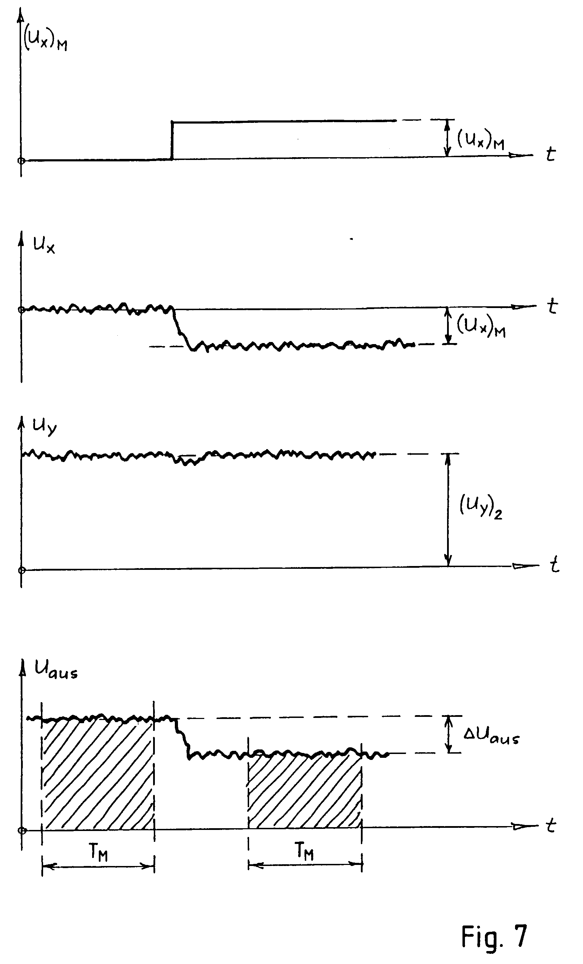

In Fig. 7 sind zum besseren Verständnis die Signale $(u_x)_M$, $u_x$, $u_y$ und $u_{aus}$ aufgezeichnet. Das Signal $\Delta u_{aus}$ wird durch Subtraktion zweier Signalpegel ermittelt, die jeweils über eine genügend lange Meßzeit $T_M$ gemittelt werden müssen, um den Einfluß von Feldstörungen und Rauschen zu verringern.

Schnelle Feldstörungen von externen Störquellen können mit dem beschriebenen Regelkreis nicht einwandfrei unterdrückt werden. Der 1.Kanal mit seiner hohen Dynamik wäre im Prinzip schon geeignet solche Störungen auszuregeln, aber das zusätzliche Rauschen in diesem Kanal zwingt dazu, den Dynamikbereich zu begrenzen. Aus diesem Grunde wurde ein weiterer Sensor, der Feldsensor 46, eingeführt, der Feldstörungen außerhalb des ganzen Magnetsystems detektieren kann. Dort sind diese Feldstörungen viel stärker als am Ort der NMR-Probe, weil sie von den leitenden Metallteilen des Kryostaten und von der supraleitenden Spule nicht abgeschirmt bzw. teilweise kompensiert werden, und dort können diese Störungen auch mit einfacheren und schneller reagierenden Meßgebern (wie z.B. Förstersonde und Hallsonde) detektiert werden. Der Nachteil dabei ist jedoch, daß das Verhältnis von Feldstörung am Ort der Probe zu externer Feldstörung frequenzabhängig ist (wegen der frequenzabhängigen Eindringtiefe in metallischen Strukturen der Magnetspule und/oder eines Kryostaten), und daß deshalb das extern detektierte Signal zuerst einer Frequenzgangkorrektur (erfolgt im Kompensator 80 der Fig. 2) unterworfen werden muß, bevor es zur Feldkorrekturspule gelangt, um dort die gewünschte Kompensation der schnellen Feldstörungen auszuführen. Ein Problem bei dieser Kompensationsmethode ist es, die richtige Frequenzgangkorrektur zu finden, die aber meßtechnisch und unter Zuhilfenahme von mathematischen Datenverarbeitungsmethoden bestimmt werden kann. Da die vom Feldsensor 46 erfaßten Störfelder als homogen angesehen werden können und meistens nur der in Richtung des $H_0$-Felds verlaufende Anteil der Störfelder berücksichtigt werden muß, reicht meist ein einziger Feldsensor aus.

Es werden nun aufgrund der Bloch'schen Gleichungen Gleichungen für das detektierte NMR-Signal abgeleitet, die teilweise bereits oben zitiert wurden.

Das Kernspinsystem ist charakterisiert durch seinen Magnetisierungsvektor $\vec{M}$, der seinerseits unter dem Einfluß eines Feldvektors $\vec{H}$ stehen soll. $\vec{H}$ und $\vec{M}$ seien durch kartesische Koordinaten definiert (siehe Fig. 3 und 4).

Die Bloch'schen Gleichungen, welche den Bewegungszustand von $\vec{M}$ definieren, lauten (siehe "Handbuch der Physik", S. Flügge, Band XXXVIII/1, S. 130, Gleichungen 2.6):

$$\frac{dM_x}{dt} + \frac{M_x}{T_2} = \gamma \, (M_y H_z - M_z H_y) \tag{1.1}$$

$$\frac{dM_y}{dt} + \frac{M_y}{T_2} = \gamma \, (M_z H_x - M_x H_z) \tag{1.2}$$

$$\frac{dM_z}{dt} + \frac{M_z - M_0}{T_1} = \gamma \, (M_x H_y - M_y H_x) \tag{1.3}$$

Wenn wir nun die xy-Ebene als komplexe Ebene neu definieren und x als die reelle und y als die imaginäre Achse bezeichnen, dann gilt:

$$\bar{F} = H_x + iH_y \tag{1.4}$$

$$\bar{G} = M_x + iM_y \tag{1.5}$$

Multipliziert man Gleichung (1.2) mit i und addiert diese zu (1.1), und führt man zudem die beiden Gleichungen (1.4) und (1.5) ein, dann lassen sich die drei Bloch'schen Gleichungen auf zwei reduzieren:

$$\frac{d\bar{G}}{dt} + (\frac{1}{T_2} + i\gamma H_z) \, \bar{G} = i\gamma M_z \bar{F} \tag{1.6}$$

$$\frac{dM_z}{dt} + \frac{M_z - M_0}{T_1} = -\gamma \, \text{Im} \, (\bar{G} \, \bar{F}^*) \tag{1.7}$$

$\bar{G}$ und $M_z$ sind die Unbekannten. "Im $(\bar{G} \, \bar{F}^*)$" ist der Imaginärteil des Produktes $\bar{G}$ mal das konjugiert komplexe von $\underline{F}$.

Nun soll der Feldvektor $\vec{H}$ schrittweise genauer definiert werden. Im ersten Schritt definieren wir nur eine konstante z-Komponente $H_0$ und setzen die x- und y-Komponenten gleich Null. Dies entspricht dem Zustand der freien Präzession der Kernspins:

$$H_x = 0 \quad )$$
$$\qquad\qquad ) \qquad \text{das heißt } \bar{F} = 0$$
$$H_y = 0 \quad )$$

$$H_z = H_0 = \omega_0/\gamma \ (= \text{statisches Polarisationsfeld})$$

Eingesetzt in Gleichung (1.6):

$$\frac{d\bar{G}}{dt} + \left(\frac{1}{T_2} + i\omega_0\right)\bar{G} = 0$$

Lösung der Differentialgleichung:

$$\bar{G} = Ae^{-\frac{t}{T_2}} e^{-i\omega_0 t} \tag{1.8}$$

Die Magnetisierungskomponente $\bar{G}$ in der xy-Ebene klingt ab mit einer Zeitkonstanten $T_2$, und was für weitere Überlegungen wichtig ist, sie rotiert im Uhrzeigersinn mit der Kreisfrequenz $\omega_0 = \gamma H_0$.

Im zweiten Schritt führen wir zusätzlich zur z-Komponente $H_2 = H_0 = \omega_0/\gamma$ ein Drehfeld $\bar{F}$ in der xy-Ebene ein, das zur Anregung des Kernspinsystems dienen soll und deshalb im gleichen Sinn wie die frei präzessierenden Spins rotieren soll, also ebenfalls im Uhrzeigersinn, aber mit einer Kreisfrequenz $\omega$, die leicht verschieden von $\omega_0$ sein soll:

$$\bar{F} = H_1 e^{-i\omega t} \tag{1.9}$$

Eingesetzt in (1.6) und 1.7) und mit $H_z = \omega_0/\gamma$ :

$$\frac{d\bar{G}}{dt} + \left(\frac{1}{T_2} + i\omega_0\right)\bar{G} = iM_z\gamma H_1 e^{-i\omega t} \tag{1.10}$$

$$\frac{dM_z}{dt} + \frac{M_z - M_0}{T_1} = -\gamma H_1 \, \mathrm{Im}\,(\bar{G}e^{-i\omega t}) \tag{1.11}$$

Die Lösung für $\bar{G}$ aus den beiden obigen Differentialgleichungen läßt sich durch eine zeitliche Amplitudenänderung a(t) und Phasenänderung $\varphi(t)$ prinzipiell darstellen:

$$\bar{G} = a(t)e^{-i(\omega t + \varphi(t))} = M_x + iM_y \tag{1.12}$$

Die Empfangsspule des NMR-Spektrometers soll in y-Richtung orientiert sein, und somit ist nur die Komponente $M_y$ maßgebend für das in der Empfangsspule induzierte Kernresonanzsignal $u_i$:

$$u_i = -k_1 \frac{dM_y}{dt}$$

$$M_y = -a(t)\sin(\omega t + \varphi(t))$$

$$u_i = k_1 \left(a(t)\left(\omega + \frac{d\varphi(t)}{dt}\right)\cos(\omega t + \varphi(t)) + \right.$$
$$\left. + \frac{da(t)}{dt}\sin(\omega t + \varphi(t))\right)$$

$$u_i = k_1\omega\left(a(t)\left(\cos(\omega t + \varphi(t)) + \frac{d\varphi(t)}{\omega dt}\cos(\omega t + \varphi(t)) + \right.\right.$$
$$\left.\left. + \frac{da(t)}{a(t)\omega dt}\sin(\omega t + \varphi(t))\right)\right)$$

Da in der NMR-Spektroskopie im allgemeinen die beiden Bedingungen

$$\omega \gg \frac{d\varphi(t)}{dt} \ , \ \omega \gg \frac{da(t)}{a(t)\,dt}$$

erfüllt sind, ist nur der erste Summand in der Gleichung für $u_i$ maßgebend:

$$u_i = k_1\,\omega\,a(t)\cos(\omega t + \varphi(t))$$

Um die komplexe Schreibweise beizubehalten, definieren wir ein komplexes NMR-Signal $\bar{U}_i$ und berücksichtigen dabei nur den Realteil:

$$\bar{U}_i = k_1\omega\,a(t)e^{-i(\omega t + \varphi(t))} \tag{1.13}$$

Durch das Ein- und Ausschalten des Empfängers mit alternierender Polarität (wie aus DE-C2-22 37 891 an sich bekannt) wird $\overline{U}_i$ mit einer periodischen Schaltfunktion m(t) (siehe Fig. 5 und 6) multipliziert. Dadurch entsteht $\overline{U}_3$:

$$\overline{U}_3 = m(t)\overline{U}_i = k_1\omega\,m(t)\,a(t)e^{-i(\omega t + \varphi(t))} \qquad (1.14)$$

Im Empfänger wird nun das Signal $\overline{U}_3$ in einer Quadraturmischstufe zweimal in den NF-Bereich hinunter gemischt, und zwar mit Hilfe von zwei Lokaloszillatoren mit gleichen Frequenzen $\omega$ wie das Signal $\overline{U}_3$, jedoch mit Phasen, die um 90° zueinander phasenverschoben sind. Mathematisch können diese beiden Mischvorgänge durch eine Multiplikation von $\overline{U}_3$ mit zwei Zeigern $g_2 \cdot e^{i\omega t}$ und $-ig_2 e^{i\omega t}$ ersetzt werden, die um 90° zueinander phasenverschoben sind, und die im entgegengesetzten Sinn rotieren wie das Signal $\overline{U}_3$. Die erste Mischung liefert $\overline{U}_{x2}$:

$$\overline{U}_{x2} = \overline{U}_3 g_2 e^{i\omega t} = k_1\omega\,g_2\,m(t)\,a(t)e^{-i\varphi(t)}$$

Die zweite Mischung liefert:

$$\overline{U}_{y2} = \overline{U}_3\,(-ig_2 e^{i\omega t}) = -\,ik_1\omega\,g_2\,m(t)\,a(t)e^{-i\varphi(t)} = -\,i\overline{U}_{x2}$$

Die tatsächlichen Quadratursignale sind definitionsgemäß durch die Realteile der komplexen Signale $\overline{U}_{x2}$ und $\overline{U}_{y2}$ gegeben:

$$u_{x2} = \mathrm{Re}\,(\overline{U}_{x2})$$

$$u_{y2} = \mathrm{Re}\,(\overline{U}_{y2}) = \mathrm{Re}\,(-i\overline{U}_{x2}) = \mathrm{Im}\,(\overline{U}_{x2})$$

Es genügt somit, nur das komplexe Signal $\overline{U}_{x2}$ zu berücksichtigen, und dabei zu beachten, daß die Signale $u_{x2}$ und $u_{y2}$ in den beiden Quadraturkanälen durch den Real- bzw. Imaginäranteil von $\overline{U}_{x2}$ gegeben sind. An Stelle von $\overline{U}_{x2}$ soll die einfachere Bezeichnung $\overline{U}_2$ benutzt werden:

$$\overline{U}_2 = \overline{U}_{x2} = k_1\omega g_2\,m(t)\,a(t)\,e^{-i\varphi(t)}$$

und da aus Gleichung (1.12) die Beziehung

$$a(t)\,e^{-i\varphi(t)} = \overline{G}e^{i\omega t}$$

abgeleitet werden kann, erhält man für $\overline{U}_2$:

$$\overline{U}_2 = k_1\omega\,g_2\,m(t)\overline{G}e^{i\omega t} \qquad (1.15)$$

Die Schaltfunktion m(t) ist in Fig. 5 und 6 dargestellt und auch in Fig. 1 eingezeichnet und setzt sich zusammen aus einzelnen Frequenzkomponenten in Abständen von $\omega_m$, wobei die erste Komponente bei $\omega_m/2$ liegt.

Durch die selektiven NF-Filter 37, 38 (siehe Fig. 1) wird nur die erste Komponente $m_1\sin(\omega_m t/2)$ übertragen. m(t) kann deshalb durch obige Funktion ersetzt werden und man erhält für das Signal am Ausgang der NF-Filter 37, 38:

$$\overline{u}_1 = k_1\omega\,g_2\,m_1\,\sin\!\left(\frac{\omega_m t}{2}\right)\overline{G}e^{i\omega t} \qquad (1.16)$$

Im anschließenden synchronen Gleichrichter 60, 62 wird die negative Halbwelle von $\sin(\omega_m t/2)$ in den positiven Bereich geklappt und daraus der Gleichstomanteil $g_3$ bestimmt. $\sin(\omega_m t/2)$ kann deshalb durch $g_3$ ersetzt werden und man erhält für das Signal am Ausgang der synchronen Gleichrichter 60, 62:

$$\overline{U} = k_1\omega\,g_2\,m_1\,g_3\,\overline{G}e^{i\omega t} \qquad \text{oder}$$

$$\overline{U} = k_{tot}\overline{G}e^{i\omega t} = u_x + iu_y$$

$$\text{mit } k_{tot} = k_1\omega\,g_2\,m_1\,g_3 \qquad (1.17)$$

$u_x$ und $u_y$ sind die Signale in den beiden Quadraturkanälen.

Gleichung (1.17) aufgelöst nach $\overline{G}$ ergibt

$$\overline{G} = \frac{\overline{U}}{k_{tot}}\,e^{-i\omega t}$$

und eingesetzt in (1.19) und (1.11) führt dies zu den gesuchten Differentialgleichungen für das detektierte NMR-Signal:

$$\frac{d\overline{U}}{dt} + \left(\frac{1}{T_2} + i(\omega_0 - \omega)\right)\overline{U} = ik_{tot}\gamma H_1 M_z \qquad (1.18)$$

$$\frac{dM_z}{dt} + \frac{M_z - M_0}{T_1} = -\frac{\gamma H_1}{k_{tot}} \, \mathrm{Im}\,(\bar{U}) = -\frac{\gamma H_1}{k_{tot}} u_y \qquad (1.19)$$

Durch Einsetzen von $\bar{U} = u_x + i u_y$ in Gleichungen (1.18) erhält man aus den obigen zwei Differentialgleichungen folgende drei Differentialgleichungen:

$$\frac{du_x}{dt} + \frac{u_x}{T_2} - (\omega_0 - \omega)u_y = 0 \qquad (1.20)$$

$$\frac{du_y}{dt} + \frac{u_y}{T_2} + (\omega_0 - \omega)u_x = k_{tot}\gamma H_1 M_z \qquad (1.21)$$

$$\frac{dM_z}{dt} + \frac{M_z - M_0}{T_1} = -\frac{\gamma H_1}{k_{tot}} u_y \qquad (1.22)$$

Untersuchung einiger Spezialfälle

Fall 1

$\omega = $ konstant

$\omega_0 = $ konstant

Nachdem das Kernspinsystem sich auf diesen Zustand eingeschwungen hat, ist der stationäre Zustand erreicht, und die zeitabhängigen Komponenten $du_x/dt$, $du_y/dt$ und $dM_z/dt$ können vernachlässigt, d.h. gleich Null gesetzt werden. Es gilt somit:

$$\frac{u_x}{T_2} - (\omega_0 - \omega)u_y = 0$$

$$\frac{u_y}{T_2} + (\omega_0 - \omega)u_x = k_{tot}\gamma H_1 M_z$$

$$\frac{M_z - M_0}{T_1} = -\frac{\gamma H_1}{k_{tot}} u_y$$

Dies ist ein Gleichungssystem mit drei Gleichungen und drei Unbekannten $u_x$, $u_y$ und $M_z$. Die Auflösung ergibt:

$$u_x = k_{tot}M_0\gamma H_1 T_2 \, \frac{T_2(\omega_0 - \omega)}{1 + T_2^2(\omega_0 - \omega)^2 + \gamma^2 H_1^2 T_1 T_2} \qquad (1.23)$$

$$u_y = k_{tot}M_0\gamma H_1 T_2 \, \frac{1}{1 + T_2^2(\omega_0 - \omega)^2 + \gamma^2 H_1^2 T_1 T_2} \qquad (1.24)$$

$$M_z = M_0 \, \frac{1 + T_2^2(\omega_0 - \omega)^2}{1 + T_2^2(\omega_0 - \omega)^2 + \gamma^2 H_1^2 T_1 T_2} \qquad (1.25)$$

$u_x$ stellt das Dispersionssignal dar,

$u_y$ das Absorptionssignal.

Fall 2

$$\omega_0 = \omega + \gamma\Delta H_0 \cos\omega_s t = \omega + \Delta\omega \cos\omega_s t$$

Dieser Fall entspricht dem Zustand, wenn der NMR-Feldstabilisator eingerastet ist, und die Larmorfrequenz $\omega_0$ der Kernspins durch Änderung der Feldstärke $H_0$ auf den Wert der Anregungsfrequenz $\omega$ geregelt wird, wobei aber noch eine periodische Feldänderung $\gamma\Delta H_0 \cos\omega_s t$ vorhanden ist mit der Störfrequenz $\omega_s$. Gesucht sind die Kernresonanzsignale $u_x$ und $u_y$ unter dem Einfluß dieser periodischen Feldänderung. Es wird sich zeigen, daß eine einfache Lösung nur im Falle kleiner Störamplituden $\Delta\omega$ vorhanden ist.

Ansatz:

$$(\omega_0 - \omega) = \Delta\omega \cos\omega_s t \qquad \text{(gegeben)}$$

$$u_x = A \cos\omega_s t + B \sin\omega_s t \qquad (1.26)$$

$$u_y = k_{tot} M_0 \gamma H_1 T_2 \frac{1}{1 + \gamma^2 H_1^2 T_1 T_2} \qquad (1.27)$$

$$M_z = \frac{M_0}{1 + \gamma^2 H_1^2 T_1 T_2} \qquad (1.28)$$

Die Ansätze für $u_y$ und $M_z$ sind die Werte der Gleichungen (1.24) bzw. (1.25), wenn $(\omega_0 - \omega) = 0$ eingesetzt wird. Die obigen Ansätze gelten für den eingeschwungenen Zustand. Eingesetzt in die Differentialgleichungen (1.20), (1.21) und 1.22) führt dies zu folgenden drei Gleichungen:

$$-A\omega_s \sin\omega_s t + B\omega_s \cos\omega_s t + (A/T_2)\cos\omega_s t + (B/T_2)\sin\omega_s t -$$

$$- \Delta\omega \cos\omega_s t \frac{k_{tot} M_0 \gamma H_1 T_2}{1 + \gamma^2 H_1^2 T_1 T_2} = 0$$

$$\frac{k_{tot} M_0 \gamma H_1}{1 + \gamma^2 H_1^2 T_1 T_2} + \Delta\omega \cos\omega_s t \, (A \cos\omega_s t + B \sin\omega_s t) =$$

$$= \frac{k_{tot} M_0 \gamma H_1}{1 + \gamma^2 H_1^2 T_1 T_2}$$

$$\frac{1}{T_2} \left( \frac{M_0}{1 + \gamma^2 H_1^2 T_1 T_2} - M_0 \right) = \frac{-M_0 \gamma^2 H_1^2 T_2}{1 + \gamma^2 H_1^2 T_1 T_2}$$

Die dritte Gleichung ist exakt erfüllt. Die zweite Gleichung kann ebenfalls erfüllt werden, wenn folgende Bedingung gilt:

$$\Delta\omega \cos\omega_s t \, (A \cos\omega_s t + B \sin\omega_s t) \ll \frac{k_{tot} M_0 \gamma H_1}{1 + \gamma^2 H_1^2 T_1 T_2} \qquad (1.29)$$

Sobald A und B berechnet sind, muß obige Ungleichung neu formuliert werden und daraus eine brauchbare Bedingung abgeleitet werden, welche den Gültigkeitsbereich der verwendeten Ansätze definiert.

Aus der ersten Gleichung wird A und B berechnet:

$$-A\omega_s + (B/T_2) = 0$$

$$B\omega_s + A/T_2 - \Delta\omega \frac{k_{tot} M_0 \gamma H_1 T_2}{1 + \gamma^2 H_1^2 T_1 T_2} = 0$$

$$A = \frac{k_{tot} M_0 \gamma H_1 T_2}{1 + \gamma^2 H_1^2 T_1 T_2} \frac{\Delta\omega T_2}{1 + \omega_s^2 T_2^2} \qquad (1.30)$$

$$B = \frac{k_{tot} M_0 \gamma H_1 T_2}{1 + \gamma^2 H_1^2 T_1 T_2} \frac{\Delta\omega T_2 \omega_s T_2}{1 + \omega_s^2 T_2^2} \qquad (1.31)$$

Eingesetzt in die Bedingung (1.29):

$$(\Delta\omega T_2)^2 \ll \frac{1 + \omega_s^2 T_2^2}{\cos^2\omega_s t + \sin\omega_s t \cos\omega_s t \, \omega_s T_2}$$

$$(\Delta\omega T_2)^2 \ll \frac{1 + \omega_s^2 T_2^2}{\sqrt{1 + \omega_s^2 T_2^2}}$$

$$(\Delta\omega T_2)^2 \ll 1$$

(1.30) und (1.31) eingesetzt in (1.26) führt zum gewünschten Resultat:

$$u_x = \frac{k_{tot}M_0\gamma H_1 T_2}{1+\gamma^2 H_1^2 T_1 T_2}\, \Delta\omega T_2\, \frac{\cos\omega_s t+ \omega_s T_2\, \sin\omega_s t}{1+\omega_s^2 T_2^2} \tag{1.32}$$

$$u_y = \frac{k_{tot}M_0\gamma H_1 T_2}{1+\gamma^2 H_1^2 T_1 T_2} \tag{1.33}$$

$$M_z = \frac{M_0}{1+\gamma^2 H_1^2 T_1 T_2} \tag{1.34}$$

wobei gelten muß

$$(\Delta\omega T_2)^2 \ll 1 \tag{1.35}$$

Man beachte, daß hier eine Feldänderung $\Delta\omega \cos \omega_s t$ nur $u_x$ beeinflußt, und sowohl $u_y$ wie auch $M_z$ unbeeinflußt bleiben.

$u_x$ läßt sich auch als Zeiger in der komplexen Ebene darstellen, indem $\cos \omega_s t + \omega_s T_2 \sin \omega_s t$ durch den Zeiger $1 - i\omega_s T_2$ ersetzt wird:

$$\cos \omega_s t + \omega_s T_2 \sin \omega_s t = \mathrm{Re}\, ((1 - i\omega_s T_2)e^{i\omega_s t})$$

Man erhält auf diese Weise einen sehr einfachen Ausdruck für $u_x$:

$$\overline{U}_x = \frac{k_{tot}M_0\gamma H_1 T_2}{1+\gamma^2 H_1^2 T_1 T_2}\, \Delta\omega T_2\, \frac{1}{1+i\omega_s T_2} \tag{1.36}$$

wobei

$$(\Delta\omega T_2)^2 \ll 1$$

Es ist leicht zu erkennen, daß der Klammerausdruck exakt der Übertragungsfunktion eines Tiefpasses entspricht mit der Grenzfrequenz $1/T_2$ (ausgedrückt als Kreisfrequenz) und mit $\omega_s$ als Übertragungsfrequenz.

Eine interessante Größe ist

$$\frac{\overline{U}_x}{u_y} = \Delta\omega T_2\, \left( \frac{1}{1+i\omega_s T_2} \right) \tag{1.37}$$

wobei

$$(\Delta\omega T_2)^2 \ll 1$$

Dieser Ausdruck ist sehr nützlich, denn er ist unabhängig von vielen Parametern wie Empfangsverstärkung $k_{tot}$, Senderamplitude $H_1$ und Sättigungsparameter $\gamma^2 H_1^2 T_1 T_2$. Für niedrige Störfrequenzen $\omega_s$ (das heißt $\omega_s^2 T_2^2 \ll 1$) und bei bekanntem $T_2$ läßt sich daraus direkt die Störamplitude $\Delta\omega$ ableiten:

$$\Delta\omega = \frac{1}{T_2}\, \frac{u_x}{u_y} \tag{1.38}$$

wobei

$$(\Delta\omega T_2)^2 \ll 1 \text{ und } (\omega_s T_2)^2 \ll 1$$

Eine weitere interessante Größe läßt sich direkt aus (1.20) ableiten, wenn man für $\omega_0 - \omega$ den Ausdruck $\Delta\omega$ einsetzt:

$$\Delta\omega = \frac{1}{T_2}\, \frac{u_x}{u_y} + \frac{1}{u_y}\, \frac{du_x}{dt} \tag{1.39}$$

Diese Gleichung gilt exakt und ist an keine Bedingungen gebunden. Im ersten Summanden erkennt man die Gleichung (1.38). Der zweite Summand mit dem Differentialquotienten $du_x/dt$ liefert die noch benötigte Größe, um die Unabhängigkeit von den beiden Bedingungen $(\Delta\omega T_2)^2 \ll 1$ und $(\omega_s T_2)^2 \ll 1$ zu gewährleisten.

**Patentansprüche**

1.  Verfahren zum Kompensieren von zeitvarianten Feldstörungen in Magnetfeldern von Elektromagneten mit hoher Feldhomogenität, insbesondere in Probenräumen von supraleitenden Elektromagneten für Messungen magnetischer Resonanz, bei welchem Verfahren das Dispersionssignal $u_x$ des magnetischen Kernresonanzsignals einer Vergleichssubstanz aufgenommen wird und zur Kompensation durch Erzeugen eines von dem Dispersionssignal abhängigen Stroms in einer Feldkorrekturspule des Elektromagneten herangezogen wird, dadurch gekennzeichnet, daß zusätzlich das Absorptionssignal $u_y$ der Vergleichssubstanz aufgenommen wird, und daß die Kompensation in Abhängigkeit von den Größen $u_x/u_y$ oder $(1/u_y)$ $(du_x/dt)$ oder einer gewichteten Kombination derselben vorgenommen wird.

2. Verfahren nach Anspruch 1, dadurch gekennzeichnet, daß die Kompensation in Abhängigkeit von der Größe $1/T_2 \cdot x/u_y$ vorgenommen wird, wobei $T_2$ die Spin-Spin-Relaxationszeit der Vergleichssubstanz ist.

3. Verfahren nach Anspruch 2, dadurch gekennzeichnet, daß das Absorptionssignal $u_y$ einer Tiefpaßfilterung unterzogen wird.

4. Verfahren nach Anspruch 1, dadurch gekennzeichnet, daß die Kompensation in Abhängigkeit von der Größe $1/T_2 \cdot u_x/u_y + 1/u_y \cdot du_x/dt$ vorgenommen wird.

5. Verfahren nach einem der vorhergehenden Ansprüche, dadurch gekennzeichnet, daß zum Kompensieren schneller externer Feldstörungen diese außerhalb des Elektromagnets erfaßt werden, einer Frequenzgangkorrektur unterzogen und dann zum Erzeugen eines Kompensationsstroms verwendet werden.

6. Verfahren nach einem der vorhergehenden Ansprüche, dadurch gekennzeichnet, daß zum Ermitteln von $T_2$ in den Regelkreis ein vorbestimmtes elektrisches Signal $(u_x)_M$ eingespeist wird, das eine Feldstörung simuliert, und daß nach dem Kompensieren der simulierten Feldstörung $T_2$ nach der Formel

$$T_2 = \frac{-(u_x)_M}{\Delta\omega (u_y)_2}$$

ermittelt wird, wobei $\Delta\omega = \gamma\Delta H_0$ die von der simulierten Störung bewirkte Frequenzänderung der Kernspinsignale, $\gamma$ das gyromagnetische Verhältnis, $\Delta H_0$ die bei der Kompensation erzeugte Feldänderung und $(u_y)_2$ ein mittels einer Tiefpaßfilterung gefilteres Absorptionssignal $u_y$ ist.

7. Vorrichtung zum Kompensieren von zeitvarianten Feldstörungen in Magnetfeldern von Elektromagneten mit hoher Feldhomogenität, insbesondere in Probenräumen von supraleitenden Elektromagneten für Messungen magnetischer Resonanz, mit einer einen phasenempfindlichen Gleichrichter (60) umfassenden Vorrichtung zum Aufnehmen des Dispersionssignals $u_x$ des magnetischen Kernresonanzsignals einer Vergleichssubstanz und zur Kompensation durch Erzeugen eines von dem Dispersionssignal abhängigen Stroms in einer Feldkorrekturspule (2) des Elektromagneten, dadurch gekennzeichnet, daß sie, insbesondere zum Durchführen eines Verfahrens nach einem der vorhergehenden Ansprüche, einen phasenempfindlichen Gleichrichter (62) zum Gewinnen des Absorptionssignals uy eines magnetischen Kernresonanzsignals aufweist, und daß sie Vorrichtungen (64, 66) zum Erzeugen mindestens einer von $u_x/u_y$ und/oder $(1/u_y)$ $(du_x/dt)$ abhängigen Größe aufweist, wobei diese Größe der Vorrichtung zur Kompensation zugeführt wird.

8. Vorrichtung nach Anspruch 7, dadurch gekennzeichnet, daß sie einen Meßumformer (66) zum Bilden der Größe $1/T_2 \cdot u_x/u_y$ aufweist, wobei $T_2$ die Spin-Spin-Relaxationszeit der Vergleichssubstanz ist.

9. Vorrichtung nach Anspruch 7 oder 8, dadurch gekennzeichnet, daß sie einen Meßumformer (64) zum Bilden der Größe $1/T_2 \cdot u_x/u_y + 1/u_y \cdot du_x/dt$ aufweist.

10. Vorrichtung nach Anspruch 8 und/oder 9, dadurch gekennzeichnet, daß mindestens einem Meßumformer (64, 66) ein Regler (68, 70) nachgeschaltet ist, an dessen Ausgang das entsprechend den Regeleigenschaften modifizierte Eingangssignal des betreffenden Reglers erscheint.

11. Vorrichtung nach den Ansprüchen 8 und 9 oder 8 bis 10, dadurch gekennzeichnet, daß sie eine Schaltvorrichtung (72) zum Auswählen der einen Größe oder der anderen Größe oder einer Kombination der Größen aufweist.

12. Vorrichtung nach Anspruch 10 oder 11, dadurch gekennzeichnet, daß sie eine Steuervorrichtung (74) aufweist, die in Abhängigkeit von dem Dispersionssignal $u_x$ und dem Absorptionssignal $u_y$ den Regler (68, 70) und/oder die Schaltvorrichtung (72) steuert.

13. Vorrichtung nach einem der Ansprüche 10 bis 12, dadurch gekennzeichnet, daß mindestens ein Regler einen integrierenden oder doppelt integrierenden Verstärker aufweist.

14. Vorrichtung nach Anspruch 8, dadurch gekennzeichnet, daß dem y-Eingang des Meßumformers (66) zum Bilden der Größe $1/T_2 \cdot u_x/u_y$ ein Tiefpaß (75) vorgeschaltet ist.

15. Vorrichtung nach einem der Ansprüche 7 bis 14, dadurch gekennzeichnet, daß zum Kompensieren schneller externer Feldstörungen außerhalb des Elektromagnets ein Feldsensor (46) vorgesehen ist.

16. Vorrichtung nach einem der Ansprüche 7 bis 15, dadurch gekennzeichnet, daß sie einen digitalen Rechner (25) aufweist, der mindestens einen Teil der Operationen der Vorrichtung rein rechnerisch ausführt.

## Claims

1. Method for compensation of time variant field disturbances in magnetic fields of electromagnets with high field homogeneity, in particular in sample volumes of superconducting electromagnets for measurements of magnetic resonance, in said method the dispersion signal $u_x$ of the nuclear magnetic resonance signal of a reference substance is acquired and taken for compensation by generation of a current dependent on the dispersion signal in a field correction coil of the electromagnet,
   characterized in that
   additionally the absorption signal $u_y$ of the reference substance is acquired and that the compensation is carried out in dependence on the quantities $u_x/u_y$ or $(1/u_y)$ $(du_x/dt)$ or on a weighted combination thereof.

2. Method according to claim 1, characterized in that the compensation is carried out in dependence on the quantity $1/T_2 \cdot u_x/u_y$, $T_2$ being the spin-spin-relaxation time of the reference substance.

3. Method according to claim 2, characterized in that the absorption signal $u_y$ is subjected to a low-pass filtration.

4. Method according to claim 1, characterized in that the compensation is carried out in dependence on the quantity $1/T_2 \cdot u_x/u_y + 1/u_y \cdot du_x/dt$.

5. Method according to anyone of the preceding claims, characterized in that for compensation of fast external field disturbances, same are detected outside the electromagnet, subjected to a frequency characteristic correction and then used for generation of a compensation current.

6. Method according to anyone of the preceding claims, characterized in that for determination of $T_2$, a pre-determined electric signal $(u_x)_M$ which simulates a field disturbance is fed into the regulating loop and that after compensation of the simulated field disturbance $T_2$ is determined according to the formula

$$T_2 = \frac{-(u_x)_M}{\Delta\omega(u_y)_2}$$

in which $\Delta\omega = \gamma\Delta H_0$ is the frequency change of the nuclear spin signals caused by the simulated disturbance, $\gamma$ the gyromagnetic relation, $\Delta H_0$ the field change generated in the compensation, and $(u_y)_2$ a low-pass filtered absorption signal $u_y$.

7. Device for compensation of time variant field disturbances in magnetic fields of electromagnets with high field homogeneity, in particular in sample volumes of superconducting electromagnets for measurements of magnetic resonance, with a device, having a phase-sensitive rectifier (60), for acquiring the dispersion signal $u_x$ of the nuclear magnetic resonance signal of a reference substance and for compensation by generation of a current dependent on the dispersion signal in a field correction coil (2) of the electromagnet,
   characterized in that
   it has, in particular for carrying out a method according to one of the preceding claims, a phase-sensitive rectifier (62) for obtaining the absorption signal $u_y$ of a nuclear magnetic resonance signal and that it has devices (64, 66) for generating at least one quantity dependent on $u_x/u_y$ and/or $(1/u_y)$ $(du_x/dt)$, with this quantity being introduced to the device for compensation.

8. Device according to claim 7, characterized in that it has a measuring transducer (66) for forming the quantity $1/T_2$

· $u_x/u_y$, with $T_2$ being the spin-spin relaxation time of the reference substance.

9. Device according to claim 7 or 8, characterized in that it has a measuring transducer (64) for forming the quantity $1/T_2 \cdot u_x/u_y + 1/u_y \cdot du_x/dt$.

10. Device according to claim 8 and/or 9, characterized in that at least one measuring transducer (64, 66) is succeeded by a regulator (68, 70), the input signal of the concerned regulator modified according to the control properties appears at the output of said regulator.

11. Device according to claim 8 and 9 or 8 through 10, characterized in that is has a switching device (72) for selecting the one quantity or the other quantity or a combination of the quantities.

12. Device according to claim 10 or 11, characterized in that it has a control device (74) which controls at least one of the group of devices consisting of regulator (68, 70) and switching device (72) in dependence on the dispersion signal $u_x$ and the absorption signal $u_y$.

13. Device according to one of the claims 10 through 12, characterized in that at least one regulator has an integrating or double-integrating amplifier.

14. Device according to claim 8, characterized in that a low-pass (75) precedes the y-input of the measuring transducer (66) for forming the quantity $1/T_2 \cdot u_x/u_y$.

15. Device according to one of the claims 7 through 14, characterized in that for compensation of fast external field disturbances a field sensor (46) is provided outside the electromagnet.

16. Device according to one of the claims 7 through 15, characterized in that it has a digital computer (25) which carries out at least part of the device's operations mathematically.

**Revendications**

1. Procédé pour la compensation de perturbations de champ variables en temps dans des champs magnétiques provenant d'électro-aimants à haute homogénéité de champ, notamment provenant, dans des chambres d'échantillonnage, d'électro-aimants supraconducteurs pour des mesures de résonance magnétique, procédé selon lequel on enregistre le signal de dispersion $u_x$ du signal de résonance magnétique nucléaire d'une substance de référence et on l'utilise pour la compensation en produisant un courant fonction du signal de dispersion dans une bobine de correction de champ de l'électro-aimant, **caractérisé** en ce qu'on enregistre en plus le signal d'absorption $u_y$ de la substance de référence, et en ce qu'on entreprend la compensation en fonction des grandeurs $u_x/u_y$ ou $(1/u_y)$ $(du_x/dt)$, ou d'une combinaison pondérée de ces grandeurs.

2. Procédé selon la revendication 1, **caractérisé** en ce qu'on entreprend la compensation en fonction de la grandeur $1/T_2 \cdot u_x/u_y$, $T_2$ étant le temps de relaxation spin-spin de la substance de référence.

3. Procédé selon la revendication 2, **caractérisé** en ce qu'on soumet le signal d'absorption $u_y$ à un filtrage passe-bas.

4. Procédé selon la revendication 1, **caractérisé** en ce qu'on entreprend la compensation en fonction de la grandeur $1/T_2 \cdot u_x/u_y + 1/u_y.du_x/dt$.

5. Procédé selon une des revendications précédentes, **caractérisé** en ce qu'afin de compenser des perturbations de champ externes rapides, on enregistre ces perturbations en dehors de l'électro-aimant, on les soumet à une correction de réponse en fréquence, puis on les utilise pour produire un courant de compensation.

6. Procédé selon une des revendications précédentes, **caractérisé** en ce qu'afin de déterminer $T_2$, on alimente dans le circuit de réglage un signal électrique prédéterminé $(u_x)_M$ qui simule une perturbation de champ, et en ce qu'après la compensation de la perturbation de champ simulée, on détermine $T_2$ d'après la formule

$$T_2 = \frac{-(u_x)_M}{\Delta\omega(u_y)_2}$$

où $\Delta\omega = \gamma\Delta H_0$ est la modification de fréquence des signaux de spin nucléaire qui est produite par la perturbation simulée, $\Delta H_0$ est la modification de champ produite lors de la compensation, et $(u_y)_2$ est un signal d'absorption $u_y$ filtré au moyen d'un filtrage passe-bas.

7. Dispositif pour la compensation de perturbations de champ variables en temps dans des champs magnétiques provenant d'électro-aimants à haute homogénéité de champ, notamment provenant, dans des chambres d'échantillonnage, d'électro-aimants supraconducteurs pour des mesures de résonance magnétique, avec un dispositif comprenant un redresseur (60) sensible à la phase et destiné à enregistrer le signal de dispersion $u_x$ du signal de résonance magnétique nucléaire d'une substance de référence, et à effectuer la compensation en produisant un courant fonction du signal de dispersion dans une bobine de correction de champ (2) de l'électro-aimant, **caractérisé** en ce que, notamment pour la mise en oeuvre d'un procédé selon une des revendications précédentes, il présente un redresseur (62) sensible à la phase pour l'obtention du signal d'absorption $u_y$ d'un signal de résonance magnétique nucléaire, et en ce qu'il présente des dispositifs (64, 66) pour produire au moins une grandeur fonction de $u_x/u_y$ et/ou $(1/u_y)(du_x/dt)$, cette grandeur étant transmise au dispositif destiné à effectuer la compensation.

8. Dispositif selon la revendication 7, **caractérisé** en ce qu'il présente un convertisseur de mesure (66) pour former la grandeur $1/T_2 . u_x/u_y$, $T_2$ étant le temps de relaxation spin-spin de la substance de référence.

9. Dispositif selon la revendication 7 ou 8, **caractérisé** en ce qu'il présente un convertisseur de mesure (64) pour former la grandeur $1/T_2 . u_x/u_y + 1/u_y . du_x/dt$.

10. Dispositif selon la revendication 8 et/ou 9, **caractérisé** en ce qu'un régulateur (68, 70) est intercalé à la suite d'au moins un convertisseur de mesure (64, 66), le signal d'entrée d'un régulateur apparaissant à la sortie de ce régulateur en étant modifié conformément aux caractéristiques de réglage.

11. Dispositif selon les revendications 8 et 9 ou 8 à 10, **caractérisé** en ce qu'il présente un dispositif de commutation (72) pour sélectionner l'une ou l'autre grandeur, ou une combinaison des grandeurs.

12. Dispositif selon la revendication 10 ou 11, **caractérisé** en ce qu'il présente un dispositif de commande (74), qui commande le régulateur (68, 70) et/ou le dispositif de commutation (72) en fonction du signal de dispersion $u_x$ et du signal d'absorption $u_y$.

13. Dispositif selon une des revendications 10 à 12, **caractérisé** en ce qu'au moins un régulateur présente un amplificateur à simple ou double intégration.

14. Dispositif selon la revendication 8, **caractérisé** en ce qu'un passe-bas (75) est intercalé avant l'entrée y du convertisseur de mesure (66) pour former la grandeur $1/T_2 . u_x/u_y$.

15. Dispositif selon une des revendications 7 à 14, **caractérisé** en ce qu'un capteur de champ (46) est prévu en dehors de l'électro-aimant pour la compensation de perturbations de champ extemes rapides.

16. Dispositif selon une des revendications 7 à 15, **caractérisé** en ce qu'il présente un calculateur numérique (25), qui accomplit purement par le calcul au moins une partie des opérations du dispositif.

Fig. 1

Fig. 2

Fig. 3

Fig. 4

Fig. 5

Fig. 6

Fig. 7